Europäisches Patentamt

European Patent Office

Office européen des brevets

(19)

(11) **EP 0 570 270 B1**

(12) **FASCICULE DE BREVET EUROPEEN**

(45) Date de publication et mention
de la délivrance du brevet:
**03.12.1997 Bulletin 1997/49**

(51) Int Cl.6: **C30B 11/00**, C22C 19/05

(21) Numéro de dépôt: **93401195.8**

(22) Date de dépôt: **11.05.1993**

(54) **Superalliage monocristallin à base de nickel notamment pour aubes de turbines de moteurs-fusées, et procédé d'obtention**

Monokristalline Superlegierung auf Nickelbasis,insbesondere für Turbinenschaufeln von Raketentriebwerken, und Herstellungsverfahren

Nickel-base single-crystal superalloy, suitable for turbine blades of rocket engines and production process

(84) Etats contractants désignés:
**DE GB IT SE**

(30) Priorité: **13.05.1992 FR 9205822**

(43) Date de publication de la demande:
**18.11.1993 Bulletin 1993/46**

(73) Titulaire: **SOCIETE EUROPEENNE DE PROPULSION**
**92150 Suresnes (FR)**

(72) Inventeurs:
• **Cornu, Daniel A.**
  **F-27200 Vernon (FR)**
• **De Monicault, Jean-Michel**
  **F-27720 Croisy S/Eure (FR)**
• **Caron, Pierre**
  **F-91940 Les Ulis (FR)**
• **Khan, Tasadduq**
  **F-78350 Jouy-En-Josas (FR)**

(74) Mandataire: **Thévenet, Jean-Bruno et al**
**Cabinet Beau de Loménie**
**158, rue de l'Université**
**75340 Paris Cédex 07 (FR)**

(56) Documents cités:
**EP-A- 0 358 185**          **EP-A- 0 382 585**
**EP-A- 0 398 264**

**Description**

Domaine de l'invention

La présente invention concerne les superalliages monocristallins à base de nickel, et plus particulièrement de tels superalliages adaptés à la fabrication d'aubes de turbines de turbopompes de moteurs-fusées cryotechniques de lanceurs de satellites ou d'avion spatiaux.

Art antérieur

On connait déjà divers types de superalliages monocristallins à base de nickel adaptés à la fabrication d'aubes de turbines à gaz de moteurs aéronautiques.

Les documents FR-A-2 557 598 et FR-A-2 555 204 décrivent ainsi des superalliages monocristallins à base de nickel, à hautes caractéristiques en fluage à chaud, destinés notamment à la fabrication d'aubes de turbomachines.

Les superalliages décrits dans les documents précités comprennent des quantités significatives de cobalt, de tungstène, de chrome, d'aluminium, de tantale, de molybdène, et de titane. Ces alliages, qui sont respectivement connus sous les dénominations "AM1" et "AM3", et sont respectivement commercialisés par IMPHY et par AUBERT et DUVAL, offrent un bon compromis entre la résistance en fluage dans le domaine de températures comprises entre 650 et 1100°C, la tenue en fatigue thermique et mécanique et la tenue à la corrosion et à l'oxydation, et sont essentiellement adaptés à des applications dans le domaine de l'aéronautique.

En revanche, de tels superalliages monocristallins ne sont pas adaptés à des turbopompes de moteurs-fusées, car ils montrent notamment une sensibilité à la fragilisation par l'hydrogène gazeux qui n'est pas compatible avec l'application envisagée.

En effet, les conditions de fonctionnement des turbines de moteur cryotechnique de fusée sont très nettement différentes de celles des turbines à gaz existantes, au sol ou sur avion.

Les turbines de moteurs cryotechniques sont alimentées par un flux de gaz chauds composé de vapeur d'eau, d'oxygène et d'hydrogène. Les pourcentages d'oxygène et d'hydrogène sont très variables selon le type de moteur. Ils sont très faibles lorsque les gaz chauds sont évacués vers l'extérieur à la sortie de la turbine, et qu'on ne s'écarte pas du rapport de mélange stoechiométrie. Il peuvent être élevés lorsque l'on s'écarte de ce rapport et même très élevé lorsque les gaz chauds alimentent une chambre de combustion en aval.

Dans ces conditions de fonctionnement, les aubes des turbines sont soumises à des contraintes très particulières. En particulier, dans de telles turbines, les démarrages peu nombreux, mais brefs, de l'ordre de une à deux secondes, avec une mise en froid de l'axe de turbine à 30 K et l'utilisation d'un démarreur pyrotechnique, les arrêts avec arrivée de gaz froid, le milieu hydrogéné qui implique un coefficient de transfert thermique très élevé entre les gaz et les aubes, entraînent des gradients thermiques et donc des contraintes d'origine thermique très élevées au sein des aubes. L'environnement fortement hydrogéné tend à limiter les problèmes d'oxydation en service, mais conduit à des problèmes de fragilisation du matériau.

Par ailleurs, la géométrie particulière des aubes de turbines à profil supersonique (aubes courtes à bord très effilé à poutre centrale épaisse) exclut la possibilité d'un refroidissement interne des aubes.

On notera que dans les alliages monocristallins à base de nickel connus les plus performants, la proportion de phase durcissante $\gamma'$ peut atteindre 70 % car il a été constaté que la résistance mécanique à chaud augmente avec la fraction volumique de précipités de phase durcissante $\gamma'$. Toutefois, ces alliages à haute résistance mécanique à chaud montrent tous une forte sensibilité à la fragilisation par l'hydrogène gazeux, de sorte que ces alliages ne sont pas utilisables de façon satisfaisante dans le domaine spatial.

On connait déjà des alliages utilisés pour la réalisation de turbines de turbopompes de moteurs-fusées, tel que le superalliage forgé à base nickel connu sous la dénomination SUPERWASPALOY. Un tel alliage, bien que satisfaisant pour la réalisation de disques de turbine forgés, ne présente cependant pas des caractéristiques optimales vis-à-vis des sollicitations rencontrées dans le domaine spatial au niveau des aubes de turbine. La tenue aux chocs thermiques n'est en effet pas suffisante pour des aubes de turbopompe de moteur cryotechnique.

Objet et description succincte de l'invention

La présente invention a pour but de remédier aux inconvénients précités et de fournir un superalliage à base de nickel présentant jusqu'à une température de l'ordre de 850°C une excellente résistance mécanique, au moins équivalente à celle de l'alliage forgé de référence SUPERWASPALOY, avec une tenue améliorée à la fatigue thermomécanique, une faible sensibilité à la fragilisation par l'hydrogène gazeux, tout en présentant une résistance satisfaisante à la corrosion, une conductibilité thermique élevée et une masse volumique réduite.

Ces buts sont atteints grâce à un superalliage à base de nickel, apte à la solidification monocristalline, notamment pour la fabrication d'aubes de turbines de turbopompes de moteurs-fusées cryotechniques, caractérisé en ce que sa composition pondérale en % est la suivante :

Fe : 22 à 28 %
Cr : 7 à 9 %
Ti : 3 à 5 %
Al : 3 à 5 %
Nb : 0,5 à 2 %
Mo : 2 à 4 %
Si : 0 à 0,5 %
Ni : complément à 100 %,

les autres éléments n'étant éventuellement présents que sous forme d'impuretés.

De façon plus particulière, les éléments suivants ne doivent être présents, en ppm ou poids que dans les proportions maximales suivantes :

C : $\leq$ 250 ppm
S : $\leq$ 20 ppm
$N_2$ : $\leq$ 12 ppm
$O_2$ : $\leq$ 10 ppm
B : $\leq$ 50 ppm
Zr : $\leq$ 80 ppm

L'alliage selon l'invention présente un excellent compromis entre la résistance mécanique à chaud et l'absence de sensibilité à la fragilisation par l'hydrogène gazeux.

Dans l'alliage selon l'invention, la fraction volumique de phase gamma prime est d'environ 55 %.

L'alliage est constitué d'une matrice gamma monocristalline, solution solide à base de nickel, fer et cobalt, renforcé par une dispersion de particules de phase gamma prime $Ni_3$ (Al,Ti,Nb) cohérentes avec la matrice, ce qui donne à l'ensemble les propriétés d'un cristal unique.

Par comparaison avec les alliages de l'art antérieur, que ceux-ci soient déjà utilisés dans le domaine spatial comme le superalliage forgé de référence SUPERWASPALOY, ou qu'ils soient des alliages monocristallins utilisés dans l'aéronautique, comme les alliages AM1 et AM3, le superalliage selon la présente invention présente un ensemble de propriétés qui sont mieux adaptées aux contraintes auxquelles sont soumises les aubes de turbines de turbopompes de moteurs cryotechniques de lanceurs de satellites ou d'avions spatiaux.

L'élaboration par solidification monocristalline dirigée confère une très bonne tenue mécanique à chaud, c'est à dire une très bonne résistance en fluage, résultant de l'absence de joint de grain. De plus, une coïncidence de la direction cristallographique <001> et de la direction radiale de l'aube, apporte une amélioration sensible de la tenue à la fatigue thermique et aux chocs thermiques, liée au bas module d'élasticité de cette direction.

Par ailleurs, la composition chimique de l'alliage selon l'invention assure une faible sensibilité à la fragilisation par l'hydrogène sous forte pression tout en garantissant une bonne tenue à la fatigue thermique, une conductibilité thermique élevée, une résistance satisfaisante à la corrosion pour l'application au domaine spatial, ainsi qu'une bonne tenue aux contraintes mécaniques à chaud résultant d'une masse spécifique faible, d'un bas coefficient de dilatation, d'une limite d'élasticité importante jusqu'à environ 850°C et d'un module d'élasticité sensiblement plus faible que celui du superalliages monocristallins utilisés en aéronautique.

On peut noter en particulier que l'alliage monocristallin à base de Nickel selon l'invention, bien qu'il contienne une proportion relativement modeste de fer et une proportion de phase durcissante gamma prime significative de l'ordre de 55%, apte à conférer une bonne résistance mécanique à chaud, montre une sensibilité à la fragilisation par l'hydrogène qui est inférieure à celle des superalliages connus.

De plus, la présence de chrome contribue à conférer au superalliage selon l'invention une très bonne résistance à l'oxydation.

L'invention concerne encore un procédé d'obtention d'un superalliage monocristallin à base de nickel du type mentionné ci-dessus, caractérisé en ce qu'il comprend une étape de solidification monocristalline dirigée selon une orientation cristallographique <001>.

De façon plus particulière on coule l'alliage métallique présentant la composition de base dans un moule en céramique préchauffé disposé dans un four sous vide, on retire lentement le moule du four pour obtenir un gradient thermique unidirectionnel permettant une solidification dirigée de l'alliage depuis l'embase refroidie du moule jusqu'à la partie supérieure de celui-ci.

Selon une autre caractéristique du procédé selon l'invention, après l'opération de solidification monocristalline dirigée, on procède à un chauffage de l'alliage pendant trois heures à une température comprise entre 1200 et 1250°C, puis on procède à un refroidissement à l'air pour remettre en solution la totalité de la phase gamma prime de l'alliage.

On effectue en outre la reprécipitation contrôlée des particules de phase gamma prime en soumettant l'alliage à un traitement thermique de revenu.

Pour effectuer la reprécipitation contrôlée des particules de phase gamma prime, on soumet l'alliage à un traitement thermique de revenu à une température comprise entre 850 et 950°C pendant 16 heures avec refroidissement lent à la vitesse de 1°C mm$^{-1}$ jusqu'à 650°C, puis en maintenant l'alliage à 650°C pendant 16 heures avec refroidissement à l'air.

## Description détaillée de modes particuliers de réalisation

D'autres caractéristiques et avantages de l'invention ressortiront de la description suivante d'un exemple particulier d'alliage conforme à l'invention, avec l'indication de compositions, de traitements et de résultats d'essais comparatifs.

Un superalliage monocristallin conforme à la définition générale donnée plus haut dans la description succincte de l'invention, a été élaboré et testé avec la composition nominale suivante respectivement en poids et en pourcentage atomique :

| Exemple I : | | | | | | | | |
|---|---|---|---|---|---|---|---|---|
| | Ni | Fe | Cr | Ti | Al | Nb | Mo | S = (Al+Ti+Nb) |
| % poids | 54,50 | 25,00 | 8,00 | 4,00 | 4,00 | 1,50 | 3,00 | |
| % atomique | 51,32 | 24,75 | 8,51 | 4,62 | 8,20 | 0,90 | 1,73 | 13,71 |

La dernière colonne indique la valeur de la somme S des concentrations atomiques en éléments générateurs de phase gamma prime (Al,Ti,Nb). La phase gamma prime est du type Ni$_3$ (Al, Ti, Nb) les éléments Al, Ti et Nb se substituant au nickel. Dans ces conditions, le pourcentage atomique de phase gamma prime dans l'alliage est approximativement égal à 4S, ce qui, pour l'exemple ci-dessus, correspond à une fraction de phase gamma prime de l'ordre de 55%.

L'élaboration de l'alliage selon l'invention implique en premier lieu un processus de solidification dirigée. La méthode de solidification monocristalline dirigée peut être basée sur la méthode de Bridgman. La solidification dirigée est réalisée dans un four sous vide. Le métal en fusion est coulé dans un moule en céramique préchauffé. Le moule est retiré lentement du four afin d'obtenir un gradient thermique unidirectionnel qui va permettre une solidification dirigée du matériau depuis l'embase refroidie du moule jusqu'à la partie supérieure. Pour obtenir une solidification monocristalline on dispose un germe monocristallin partiellement refondu, à l'embase du moule; ou on utilise un sélecteur de grain à hélice ou à chicanes.

Après élaboration par solidification monocristalline selon une orientation cristallographique <001>, l'alliage a été chauffé pendant trois heures à une température comprise entre 1200 et 1250°C, puis refroidi à l'air, afin de remettre en solution la totalité de la phase gamma prime.

La reprécipitation contrôlée des particules de phase gamma prime a été effectuée en soumettant l'alliage à un premier traitement thermique de revenu à une température comprise entre 850 et 950°C pendant 16 heures avec refroidissement lent à la vitesse de 1°C.mm$^{-1}$ jusqu'à 650°C, puis en maintenant l'alliage à 650°C pendant 16 heures avec refroidissement à l'air.

Les températures et durées des traitements thermiques sont choisies de manière à optimiser les propriétés de l'alliage, ainsi que l'homme de métier est en mesure de le faire grâce à son expérience. Ces traitements thermiques permettent d'éliminer la plupart des défauts subsistant après coulée, tels que la présence d'un réseau dendritique assez grossier, de ségrégations de fer, niobium, titane.

Au terme de ces traitements thermiques, l'alliage contient une fraction volumique de phase gamma prime de l'ordre de 55 % qui est fonction de la composition. La phase gamma prime est dispersée de manière homogène dans l'alliage sous la forme de particules dont la taille moyenne est comprise entre 20 et 100nm.

Les caractéristiques remarquables de l'alliage selon l'exemple I, sont comparées dans les tableaux I à III à celles de divers superalliages de référence. L'alliage selon l'exemple 1 dénommé "THYMONEL 8" est parmi les superalliages monocristallins expérimentaux contenant du chrome, une teneur réduite en fer et une fraction volumique de phase gamma prime significative celui présentant le meilleur ensemble de propriétés. Parmi les superalliages de l'art antérieur figurant dans les tableaux I à III, le superalliage forgé de référence SUPERWASPALOY (NC20K14) est utilisé couramment pour la fabrication d'aubes de turbopompes de moteur de fusée tandis que les superalliages monocristallins AM1 et AM3 sont destinés à la fabrication d'aubes de turbines de turbomachines aéronautiques et sont représentatifs de cette classe d'alliages.

Les essais de traction monotone sur éprouvettes lisses ont été effectués à la température ambiante, à 700 et 850°C sur ces différents alliages. Dans le cas des alliages monocristallins les caractéristiques de traction ont été mesurées selon une direction cristallographique <001> qui est la direction naturelle de croissance et qui coïncide avec la direction de la contrainte centrifuge dans le cas des aubes.

La sensibilité à la fragilisation par l'hydrogène gazeux des différents alliages a été évaluée par des essais de traction sur éprouvettes entaillées. Les éprouvettes entaillées (entaille circulaire, $K_t = 6,2$) sont rompues soit dans l'air sous pression atmosphérique, soit sous une pression d'hydrogène de 100 bar. Les essais ont été effectués à la température ambiante. La sensibilité à la fragilisation par l'hydrogène est caractérisée par le rapport $R_{H2}/R_{Air}$ = (contrainte à rupture sous hydrogène)/(contrainte à rupture sous air). Un rapport $R_{H2}/R_{Air} = 1$ indique une absence de sensibilité à la fragilisation par l'hydrogène. Le tableau III donne la valeur du rapport $R_{H2}/R_{Air}$ pour l'alliage THYMONEL 8 selon l'exemple 1 comparée à celles obtenues dans les mêmes conditions pour les alliages de référence.

Comparé aux alliages monocristallins aéronautiques AM1 et AM3, l'alliage de l'invention THYMONEL 8 montre une sensibilité nettement plus faible à la fragilisation par l'hydrogène, cette sensibilité étant également plus faible que celle de l'alliage forgé de référence SUPERWASPALOY.

Un autre point remarquable est la densité, d = 7,8 de l'alliage de l'invention nettement plus faible que celle des alliage monocristallins destinés à des applications aéronautiques, et également plus faible que celle de l'alliage forgé SUPERWASPALOY. Ce gain est particulièrement intéressant car il conduit à une réduction de la masse des aubes et en conséquence à une diminution de la contrainte centrifuge à laquelle est soumis le disque. Cet aspect est crucial dans le cas d'aubes de turbopompes où les vitesses de rotation sont très élevées.

Comparé à l'alliage forgé de référence SUPERWASPALOY, l'alliage de l'invention THYMONEL 8 montre une résistance à la traction supérieure entre la température ambiante et 850°C. Cette supériorité est encore plus manifeste si on compare les résistances spécifiques.

Il est par ailleurs remarquable que le module d'Young de l'alliage THYMONEL 8 soit inférieur à ceux des alliages monocristallins de référence solidifiés selon la même orientation <001>. Comparé à l'alliage forgé de référence SUPERWASPALOY, l'alliage monocristallin de l'invention THYMONEL 8 montre un module d'Young très nettement inférieur (114 GPa comparé à 213 GPa).

En résumé, l'alliage de l'invention THYMONEL 8 montre pour une utilisation sous forme d'aube monocristalline pour turbopompe de moteur de fusée un ensemble d'avantages significatifs par rapport au superalliage forgé de référence SUPERWASPALOY :

.    sensibilité à la fragilisation par l'hydrogène inférieure (gain de 14 %)
.    masse volumique inférieure (gain de 5%).
.    module d'Young inférieur (gain de 46%).
.    résistance en traction supérieure.

La composition et la réalisation de l'alliage selon l'invention ont été mises au point de manière à améliorer la tenue des chocs thermiques et à accroître la compatibilité avec le milieu hydrogène en tenant compte du fait que :

a) la tenue aux chocs thermiques croît avec le coefficient K1 suivant :

$$K1 = \frac{K \times Re}{E \times \alpha}$$

avec

K =    conductivité thermique
Re =    limite élastique
E =    module d'élasticité
X =    coefficient de dilatation

b) La compatibilité avec le milieu hydrogène résulte :

-    d'une composition chimique adaptée
-    d'une microstructure qui évite les phénomènes de piégeage et pour laquelle la diffusion de l'hydrogène, au cours de la déformation plastique, se réalise par un réseau dispersé et non concentré de dislocation,
-    d'une limite d'élasticité élevée qui retarde la déformation plastique.

Tableau I : Caractéristiques de l'alliage THYMONEL 8 selon l'invention comparées à celles d'alliages de référence.

| Alliage | Densité | Coefficient de dilatation linéaire $\alpha_m^{20°C-T}$ $(10^{-6}°C^{-1})$ | | Module d'Young à 20°C E (GPa) | Charge limite élastique Re 0,2 % (MPa) | | | Charge de rupture Rm (MPa) | | |
|---|---|---|---|---|---|---|---|---|---|---|
| | | 400°C | 850°C | | 20°C | 700°C | 850°C | 20°C | 700°C | 850°C |
| THYMONEL 8(ex1) | 7,8 | 13 | 15,6 | 114 | 1035 | 1122 | 560 | 1315 | 1195 | 560 |
| SUPERWASPALOY | 8,2 | 13,1 | 15,6 | 213 | 985 | 680 | 380 | 1420 | 1030 | 500 |
| AM1 | 8,6 | 12,5 | 13,5 | 130 | 1050 | 1130 | 950 | 1050 | 1250 | 970 |
| AM3 | 8,25 | 12,5 | 13,5 | 130 | 920 | 1050 | 870 | 1030 | 1100 | 900 |

Tableau II : Caractéristiques de l'alliage THYMONEL 8 selon l'invention comparées à celles d'alliages de référence (caractéristiques spécifiques de traction)

| Alliage | Densité d | Coefficient de dilatation linéaire $\alpha_m^{20°C-T}$ $(10^{-6}°C^{-1})$ | | Module d'Young à E (GPa) | Re 0,2 % /d (MPa) | | | Rm/d (MPa) | | |
|---|---|---|---|---|---|---|---|---|---|---|
| | | 400°C | 850°C | | 20°C | 700°C | 850°C | 20°C | 700°C | 850°C |
| THYMONEL 8(ex1) | 7,8 | 13 | 15,6 | 114 | 133 | 144 | 72 | 169 | 153 | 72 |
| SUPERWASPALOY | 8,2 | 13,1 | 15,6 | 213 | 120 | 83 | 46 | 173 | 126 | 61 |
| AM1 | 8,6 | 12,5 | 13,5 | 130 | 122 | 131 | 110 | 122 | 145 | 113 |
| AM3 | 8,25 | 12,5 | 13,5 | 130 | 112 | 127 | 105 | 125 | 133 | 109 |

EP 0 570 270 B1

Tableau III :

| Sensibilité à la fragilisation par l'hydrogène gazeux (p =100 bar) à la température ambiante de divers superalliages pour aubes. | |
|---|---|
| Alliage | $R_{H2}/R_{Air}$ |
| THYMONEL 8(ex1) | 0,89 |
| SUPERWASPALOY | 0,75 |
| AM1 | 0,46 |
| AM3 | 0,54 |

**Revendications**

1. Superalliage monocristallin à base de nickel, notamment pour la fabrication d'aubes de turbines de turbopompes de moteurs-fusées cryotechniques, caractérisé en ce que sa composition pondérale en % est la suivante :

Fe : 22 à 28 %
Cr : 7 à 9 %
Ti : 3 à 5 %
Al : 3 à 5 %
Nb : 0,5 à 2 %
Mo : 2 à 4 %
Si : 0 à 0,5 %
Ni : complément à 100 %,

les autres éléments n'étant éventuellement présents que sous forme d'impuretés.

2. Superalliage selon la revendication 1, caractérisé en ce qu'il présente une composition comprenant les éléments essentiels suivants, en % en poids

Ni = 54,50 %
Fe = 25,00 %
Cr = 8,00 %
Ti = 4,00 %
Al = 4,00 %
Nb = 1,50 %
Mo = 3,00 %,

les autres éléments n'étant éventuellement présents que sous forme d'impuretés.

3. Superalliage selon les revendications 1 ou 2, caractérisé en ce qu'il ne comprend du carbone (C) à titre d'impureté que dans une proportion inférieure ou égale à 250 ppm en poids.

4. Superalliage selon l'une quelconque des revendications 1 à 3, caractérisé en ce qu'il ne comprend du soufre (S) à titre d'impureté que dans une proportion inférieure ou égale à 20 ppm en poids.

5. Superalliage selon l'une quelconque des revendications 1 à 4, caractérisé en ce qu'il ne comprend du bore (B) à titre d'impureté que dans une proportion inférieure ou égale à 50 ppm en poids.

6. Superalliage selon l'une quelconque des revendications 1 à 5, caractérisé en ce qu'il ne comprend du zirconium à titre d'impureté que dans une proportion inférieure ou égale à 80 ppm en poids.

7. Superalliage selon l'une quelconque des revendications 1 à 6, caractérisé en ce qu'il ne comprend de l'azote ($N_2$) et de l'oxygène ($O_2$) à titre d'impuretés que dans des proportions inférieures ou égales respectivement à 12 ppm et 10 ppm en poids.

**8.** Superalliage selon l'une quelconque des revendications 1 à 7, caractérisé en ce qu'il comprend une fraction volumique de phase gamma prime de l'ordre de 55 %.

**9.** Superalliage selon la revendication 8, caractérisé en ce que la phase gamma prime est dispersée de manière homogène dans l'alliage sous la forme de particules dont la taille moyenne est comprise entre 20 et 100 nm.

**10.** Article en superalliage selon l'une quelconque des revendications 1 à 9, notamment aube de turbine de turbopompe de moteur-fusée cryotechnique pour lanceur de satellites ou avion spatial.

**11.** Procédé d'obtention d'un superalliage monocristallin à base de nickel selon l'une quelconque des revendications 1 à 9, caractérisé en ce qu'il comprend une étape de solidification monocristalline dirigée selon une orientation cristallographique <001>.

**12.** Procédé selon la revendication 11, caractérisé en ce qu'on coule l'alliage métallique présentant la composition de base dans un moule en céramique préchauffé disposé dans un four sous vide, et on retire lentement le moule du four pour obtenir un gradient thermique unidirectionnel permettant une solidification dirigée de l'alliage depuis l'embase refroidie du moule jusqu'à la partie supérieure de celui-ci.

**13.** Procédé selon la revendication 12, caractérisé en ce que, pour obtenir une solidification monocristalline, on dispose un germe monocristallin partiellement refondu, à l'embase du moule.

**14.** Procédé selon la revendication 12, caractérisé en ce que, pour obtenir une solidification monocristalline on utilise un sélecteur de grain à hélice ou à chicane.

**15.** Procédé selon l'une quelconque des revendications 11 à 14, caractérisé en ce que, après l'opération de solidification monocristalline dirigée, on procède à un chauffage de l'alliage pendant trois heures à une température comprise entre 1200 et 1250°C, puis on procède à un refroidissement à l'air pour remettre en solution la totalité de la phase gamma prime de l'alliage.

**16.** Procédé selon la revendication 15, caractérisé en ce que l'on effectue en outre la reprécipitation contrôlée des particules de phase gamma prime en soumettant l'alliage à un traitement thermique de revenu.

**17.** Procédé selon la revendication 16, caractérisé en ce que pour effectuer la reprécipitation contrôlée des particules de phase gamma prime, on soumet l'alliage à un traitement thermique de revenu à une température comprise entre 850 et 950°C pendant 16 heures avec refroidissement lent à la vitesse de 1°C mm$^{-1}$ jusqu'à 650°C, puis en maintenant l'alliage à 650°C pendant 16 heures avec refroidissement à l'air.

**Patentansprüche**

**1.** Monokristalline Superlegierung auf Nickelbasis, insbesondere für die Herstellung von Turbinenschaufeln von Turbopumpen für kryotechnische Raketenantriebe, dadurch gekennzeichnet, daß ihre Zusammensetzung in Gewichtsprozent die folgende ist:

Fe : 22 bis 28%
Cr: 7 bis 9%
Ti: 3 bis 5%
Al: 3 bis 5%
Nb : 0,5 bis 2%
Mo: 2 bis 4%
Si : 0 bis 0,5%
Ni : Ergänzung bis auf 100%,

wobei die anderen Elemente ggf. nur in Form von Verunreinigungen vorliegen.

**2.** Superlegierung nach Anspruch 1, dadurch gekennzeichnet, daß sie eine Zusammensetzung aufweist, die die folgenden wesentlichen Elemente in Gewichtsprozent aufweist:

Ni = 54,50%
Fe = 25,00%
Cr = 8,00%
Ti = 4,00%
Al = 4,00%
Nb = 1,50%
Mo = 3,00%,

wobei die anderen Elemente ggf. nur in Form von Verunreinigungen vorliegen.

3. Superlegierung nach den Ansprüchen 1 oder 2, dadurch gekennzeichnet, daß sie Kohlenstoff (C) als Verunreinigung nur in einem Anteil von weniger als oder gleich 250 Gewichts-ppm enthält.

4. Superlegierung nach einem beliebigen der Ansprüche 1 bis 3, dadurch gekennzeichnet, daß sie Schwefel (S) als Verunreinigung nur in einem Anteil von weniger als oder gleich 20 Gewichts-ppm enthält.

5. Superlegierung nach einem beliebigen der Ansprüche 1 bis 4, dadurch gekennzeichnet, daß sie Bor (B) als Verunreinigung nur in einem Anteil von weniger als oder gleich 50 Gewichts-ppm enthält.

6. Superlegierung nach einem beliebigen der Ansprüche 1 bis 5, dadurch gekennzeichnet, daß sie Zirkonium als Verunreinigung nur in einem Anteil von weniger als oder gleich 80 Gewichts-ppm enthält.

7. Superlegierung nach einem beliebigen der Ansprüche 1 bis 6, dadurch gekennzeichnet, daß sie Stickstoff ($N_2$) und Sauerstoff ($O_2$) als Verunreinigungen nur in einem Anteil von weniger als oder gleich 12 bzw. 10 Gewichts-ppm enthält.

8. Superlegierung nach einem beliebigen der Ansprüche 1 bis 7, dadurch gekennzeichnet, daß sie einen Volumenanteil an $\gamma'$-Phase von etwa 55% enthält.

9. Superlegierung nach Anspruch 8, dadurch gekennzeichnet, daß die $\gamma'$-Phase in der Legierung homogen in Form von Teilchen dispergiert ist, deren mittlere Größe zwischen 20 und 100 nm liegt.

10. Gegenstand aus Superlegierung gemäß einem beliebigen der Ansprüche 1 bis 9, insbesondere eine Turbinenschaufel einer Turbopumpe eines kryotechnischen Raketenantriebs für eine Satelliten-Antriebsrakete oder einen Raumflugkörper.

11. Verfahren zur Herstellung einer monokristallinen Superlegierung auf Nickelbasis nach einem beliebigen der Ansprüche 1 bis 9, dadurch gekennzeichnet, daß es einen Schritt einer in einer kristallographischen Ausrichtung <001> gesteuerten monokristallinen Erstarrung enthält.

12. Verfahren nach Anspruch 11, dadurch gekennzeichnet, daß man die die Basiszusammensetzung aufweisende metallische Legierung in eine vorgewärmte Keramik-Gußform gießt, die sich in einem Vakuumofen befindet, und daß man die Gußform langsam aus dem Ofen entfernt, um einen unidirektionalen Temperaturgradienten zu erhalten, der eine gesteuerte Erstarrung der Legierung vom abgekühlten Boden der Gußform bis zu ihrem oberen Bereich ermöglicht.

13. Verfahren nach Anspruch 12, dadurch gekennzeichnet, daß man zum Erhalt einer monokristallinen Erstarrung einen teilweise wiedergeschmol-zenen monokristallinen Keim am Boden der Gußform anordnet.

14. Verfahren nach Anspruch 12, dadurch gekennzeichnet, daß man zum Erhalt einer monokristallinen Erstarrung einen schrauben- oder schikanenförmigen Kornselektor verwendet.

15. Verfahren nach einem beliebigen der Ansprüche 11 bis 14, dadurch gekennzeichnet, daß man nach dem Vorgang der gesteuerten monokristallinen Erstarrung die Legierung während drei Stunden auf eine Temperatur zwischen 1200 und 1250°C erwärmt und dann eine Luftkühlung durchführt, um die Gesamtheit der $\gamma'$-Phase der Legierung wieder in Lösung zu versetzen.

16. Verfahren nach Anspruch 15, dadurch gekennzeichnet, daß man außerdem die gesteuerte Wiederausscheidung

der Teilchen der $\gamma$-Phase durchführt, indem man die Legierung einer Aushärtungs-Wärmebehandlung unterzieht.

17. Verfahren nach Anspruch 16, dadurch gekennzeichnet, daß man zur gesteuerten Wiederausscheidung der Teilchen der $\gamma$-Phase die Legierung einer Aushärtungs-Wärmebehandlung bei einer Temperatur zwischen 850 und 950°C während 16 Stunden mit langsamer Abkühlung bei der Geschwindigkeit von 1°C mm$^{-1}$ bis auf 650°C unterzieht und dann die Legierung während 16 Stunden mit nachfolgender Luftkühlung auf 650°C hält.

**Claims**

1. Monocrystalline superalloy based on nickel, especially for the manufacture of turbine vanes of turbine pumps of cryotechnic rocket engines, characterized in that its weight composition in % is the following:

   Fe : 22 to 28 %
   Cr : 7 to 9 %
   Ti : 3 to 5 %
   Al : 3 to 5 %
   Nb : 0.5 to 2 %
   Mo : 2 to 4 %
   Si : 0 to 0.5 %
   Ni : remainder to 100 %

   the other elements being possibly present only in the form of impurities.

2. Superalloy according to Claim 1, characterized in that it has a composition including the following essential elements, in % by weight

   Ni = 54.50 %
   Fe = 25.00 %
   Cr = 8.00 %
   Ti = 4.00 %
   Al = 4.00 %
   Nb = 1.50 %
   Mo = 3.00 %

   the other elements being possibly present only in the form of impurities.

3. Superalloy according to Claims 1 or 2, characterized in that it includes carbon (C) as impurity only in a proportion lower than or equal to 250 ppm by weight.

4. Superalloy according to any one of Claims 1 to 3, characterized in that it includes sulphur (S) as impurity only in a proportion lower than or equal to 20 ppm by weight.

5. Superalloy according to any one of Claims 1 to 4, characterized in that it includes boron (B) as impurity only in a proportion lower than or equal to 50 ppm by weight.

6. Superalloy according to any one of Claims 1 to 5, characterized in that it includes zirconium as impurity only in a proportion lower than or equal to 80 ppm by weight.

7. Superalloy according to any one of Claims 1 to 6, characterized in that it includes nitrogen ($N_2$) and oxygen ($O_2$) as impurities only in proportions lower than or equal to 12 ppm and 10 ppm by weight respectively.

8. Superalloy according to any one of Claims 1 to 7, characterized in that includes a volume fraction of gamma prime phase of about 55 %.

9. Superalloy according to Claim 8, characterized in that the gamma prime phase is dispersed homogeneously in the alloy in the form of particles whose mean size is between 20 and 100 nm.

**10.** Article made of superalloy according to any one of Claims 1 to 9, especially turbine vane of a turbine pump of a cryotechnic rocket engine for a satellite-launcher or space aircraft.

**11.** Process for obtaining a monocrystalline superalloy based on nickel, according to any one of Claims 1 to 9, characterized in that it includes a stage of monocrystalline solidification directed according to a <001> crystallographic orientation.

**12.** Process according to Claim 11, characterized in that the metal alloy exhibiting the base composition is cast in a preheated ceramic mould placed in a furnace under vacuum and the mould is slowly withdrawn from the furnace to obtain a unidirectional thermal gradient permitting a directed solidification of the alloy from the cooled baseplate of the mould as far as the upper portion thereof.

**13.** Process according to Claim 12, characterized in that, to obtain a monocrystalline solidification, a partially remelted monocrystalline seed is placed at the baseplate of the mould.

**14.** Process according to Claim 12, characterized in that, to obtain a monocrystalline solidification, a helix or chicane grain selector is employed.

**15.** Process according to any one of Claims 11 to 14, characterized in that, after the directed monocrystalline solidification operation, heating of the alloy for three hours at a temperature of between 1200 and 1250°C is performed and then cooling with air is performed, to redissolve all of the gamma prime phase of the alloy.

**16.** Process according to Claim 15, characterized, in addition, in that the controlled reprecipitation of the particles of gamma prime phase is performed by subjecting the alloy to a tempering heat treatment.

**17.** Process according to Claim 16, characterized in that, to perform the controlled reprecipitation of the particles of gamma prime phase, the alloy is subjected to a tempering heat treatment at a temperature of between 850 and 950°C for 16 hours with slow cooling at a rate of 1°C mm$^{-1}$ to 650°C and then by maintaining the alloy at 650°C for 16 hours with cooling with air.